Europäisches Patentamt

European Patent Office

Office européen des brevets

(11) Veröffentlichungsnummer : **0 049 007**
**B1**

(12) **EUROPÄISCHE PATENTSCHRIFT**

(45) Veröffentlichungstag der Patentschrift :
23.05.84

(21) Anmeldenummer : 81200901.7

(22) Anmeldetag : 12.08.81

(51) Int. Cl.³ : **C 04 B 37/02, C 04 B 31/14,
B 23 K 35/38**

(54) Verfahren zum direkten Verbinden von Kupferfolien mit Oxidkeramiksubstraten.

(30) Priorität : 25.09.80 DE 3036128

(43) Veröffentlichungstag der Anmeldung :
07.04.82 Patentblatt 82/14

(45) Bekanntmachung des Hinweises auf die Patenterteilung : 23.05.84 Patentblatt 84/21

(84) Benannte Vertragsstaaten :
CH DE FR GB IT LI

(56) Entgegenhaltungen :
DE-A- 2 533 524
DE-A- 2 746 894
FR-A- 2 181 049
GB-A-   761 045
US-A- 2 564 738
US-A- 3 911 553
US-A- 3 994 430

(73) Patentinhaber : BBC Aktiengesellschaft Brown,
Boveri & Cie.
Haselstrasse
CH-5401 Baden (CH)

(72) Erfinder : Berndt, Dietmar, Dr.
Wielandstrasse 30
6900 Heidelberg (DE)
Erfinder : Neidig, Arno, Dr.
Brühlerweg 42
6831 Plankstadt (DE)
Erfinder : Wahl, Georg, Dr.
Franz-List-Strasse 9
D-6904 Eppelheim (DE)
Erfinder : Wittmer, Mark, Dr.
Rutell Nr. 11
5405 Baden-Dattwil (CH)

(74) Vertreter : Dahlmann, Gerhard, Dipl.-Ing. et al
c/o Brown Boveri & Cie., AG Zentralbereich ZPT
Postfach 351
D-6800 Mannheim (DE)

EP 0 049 007 B1

## Beschreibung

Die Erfindung betrifft ein Verfahren zum direkten Verbinden von Kupferfolien, die oberflächlich eine Kupferoxidschicht tragen, mit Oxidkeramiksubstraten durch Erhitzen des mit der Kupferfolie belegten Keramiksubstrates in sauerstoffhaltiger Atmosphäre bis zu einer Temperatur oberhalb der eutektischen Temperatur von Cu und $Cu_2O$, aber unterhalb der Schmelztemperatur von Cu.

Verfahren zum direkten Verbinden von Kupfer und Oxidkeramik sind beispielsweise bekannt aus DE-A 23 19 854, DE-A 25 08 224, DE-A 26 33 869, GB-A 761 045, GB-A 784 931, US-A 3 010 188 und US-A 3 676 292. Außerdem sind weitere Publikationen bekannt, die auf die Arbeiten der in den obengenannten Offenlegungsschriften benannten Erfinder zurückgehen.

Haftfeste und vakuumdichte Verbindungen von Kupfer mit Glas oder Keramik sind in der Vergangenheit bei der Herstellung von Vakuumröhren weit verbreitet gewesen. Es wird beispielsweise verwiesen auf das Buch von W. Espe : « Werkstoffkunde der Hochvakuumtechnik », VEB Deutscher Verlag der Wissenschaften, Berlin 1959, wo auf Seite 301/302 ausgeführt ist, daß « der P-Gehalt des Kupfers 0,005 % nicht überschreiten darf, da sonst der zum vakuumdichten Anschmelzen notwendige Kupferoxidüberzug nicht ausreichend fest am Mutterkupfer haften bleibt ». Weitere allgemeine Hinweise finden sich auch in Lueger « Lexikon der Fertigungstechnik und Arbeitsmaschinen », Deutsche Verlags-Anstalt Stuttgart 1967, Stichwort « Glas ».

In der DE-A 26 33 869 ist ein Verfahren beschrieben, bei dem eine Metallfolie, bevorzugt aus Kupfer, zunächst auf einer Dicke zwischen 200 und 5 000 Å oxidiert wird, worauf die Metallfolie mit der Oxidschicht in Kontakt mit einem Oxidkeramiksubstrat, bevorzugt aus Aluminium- oder Berylliumoxid, gebracht wird, worauf Metallfolie und Substrat in einer inerten Atmosphäre bei einer Temperatur zwischen der eutektischen Temperatur (1 065 °C) von Kupfer und Kupferoxid und der Schmelztemperatur (1 083 °C) von Kupfer solange erhitzt werden, bis sich eine untereutektische Schmelze zwischen Kupfer und dem Substrat gebildet hat. Erhitzen in inerter Atmosphäre führt jedoch nicht zu der gewünschten haftfesten Verbindung zwischen Kupfer und Keramik, da sich bei den gegebenen Verfahrenstemperaturen CuO zu $Cu_2O$ und $Cu_2O$ zu Cu reduziert, wenn nicht in der umgebenden Atmosphäre ein gewisser minimaler Sauerstoff-Partialdruck aufrecht erhalten wird. Diese Tatsache ergibt sich beispielsweise aus einer Veröffentlichung der Akademie der Wissenschaften der UdSSR, Institut für Metallurgie A.A. Baikof : « Druck und Zusammensetzung des Dampfes über den Oxiden der chemischen Elemente », von E. K. Kasenas und D. M. Tschischikof, Moskau 1976, Seiten 145 bis 150, insbesondere Bild 28 auf Seite 147. Reduziertes Cu verbindet sich jedoch nicht mit Keramik.

In dieser Patentanmeldung wird auch vorgeschlagen, anstelle eines voroxidierten Kupfers ein sauerstoffhaltiges Kupfermaterial ohne Oxidüberzug zu verwenden. Abgesehen davon, daß auch hierbei keine Bindung zwischen Kupfer und Keramik entstehen kann, wenn nicht ein Mindestsauerstoffpartialdruck in der Ofenatmosphäre aufrechterhalten bleibt, hat es sich bei Versuchen herausgestellt, daß der im Metall gelöste Sauerstoff an die Berührungsfläche zwischen Kupfer und Keramik diffundiert und dort eingeschlossen bleibt, was zur Bildung von Blasen und damit zu einer mangelhaften Bindung zwischen Metall und Keramik führt.

Das in der DE-A 23 19 854 beschriebene Verfahren unterscheidet sich von dem soeben beschriebenen dadurch, daß eine blanke, nicht voroxidierte Metallfolie, insbesondere aus Kupfer, in reaktiver, insbesondere sauerstoffhaltiger Atmosphäre mit dem Oxidkeramiksubstrat verbunden werden soll. Bei diesem Verfahren muß der Sauerstoff in der Atmosphäre zunächst das Kupfer oberflächlich oxidieren, bevor der eigentliche Verbindungsprozeß ablaufen kann. Es hat sich jedoch herausgestellt, daß insbesondere bei großflächigen Verbindungen zwischen Keramik und Kupfer der Sauerstoff nicht in ausreichender Menge in den Spalt zwischen Keramik und Kupfer eindringen kann, so daß blasenartige Stellen ohne Haftung entstehen. Außerdem besteht die Gefahr, daß bei den angegebenen Sauerstoffmengen die Kupferfolie auf der vom Keramiksubstrat abgewendeten Seite mit einer dicken, schwarzen Kupferoxidschicht überzogen wird, die in einem zusätzlichen Arbeitsgang wieder entfernt werden muß, bevor eine Weiterverarbeitung, insbesondere in der Halbleiter-Industrie, möglich ist. Von einem Sauerstoffanteil unter 0,01 Vol.% wird ausdrücklich abgeraten, da dann in Folge unzureichender Oxidbildung, keine Bindung zwischen Kupfer und Keramik zustande komme.

Das in der DE-A 25 08 224 beschriebene « verbessert » Verfahren verwendet wieder voroxidiertes Kupfer, um auch bei großflächigen Verbindungen eine Haftung an allen Stellen zu ermöglichen. Außerdem wird die Kupferfolie so vorgebogen, daß sie sich beim Erhitzen nur allmählich auf das Keramiksubstrat legt. Dabei sollen etwaige Gasblasen nach außen herausgedrückt werden. Dieses Verfahren ist jedoch aufwendig und umständlich ; auch ist, wenn Kupferfolie und/oder Keramik kompliziert vorgeformt sind, ein Biegen der Kupferfolie nicht immer möglich oder die Folie legt sich nicht gleichmäßig auf das Substrat. Außerdem überzieht sich auch bei der in dieser Offengungsschrift angegebenen Sauerstoffmenge von 0,01 bis 0,5 Vol.% die freiliegende Kupferfläche mit einer dicken, schwarzen Oxidschicht, die nachträglich erst wieder beseitigt werden muß.

Der vorliegenden Erfindung liegt die Aufgabe zugrunde, das zuletzt beschriebene bekannte Verfahren derart weiterzubilden, daß auf einfache Weise eine blasenfreie Verbindung zwischen Kupferfolie und Keramik und gleichzeitig eine praktisch oxidfreie Kupferoberfläche erzielt wird.

Diese Aufgabe wird dadurch gelöst, daß das Erhitzen im Vakuumofen bei einem Druck von höchstens 1,0, vorzugsweise 0,1 mbar und einem Sauerstoff-Partialdruck zwischen 0,001 und 0,1 mbar in der Ofenatmosphäre durchgeführt wird und daß während des Abkühlens der Sauerstoff-Partialdruck unter 0,005 mbar gehalten wird.

Damit ergeben sich die Vorteile, daß die Kupferfolie eben auf das Keramiksubstrat aufgelegt werden kann, daß etwaige Gasreste zwischen Metallfolie und Substrat abgesaugt werden, daß im Gegensatz zu den bekannten Verfahren, die alle bei Atmosphärendruck ablaufen, nur sehr geringe Gasmengen — Inertgas und Sauerstoff — verbraucht werden, daß eine feste Verbindung zwischen Kupfer und Keramik erreicht wird, daß der chemisch bedingte Sauerstoff-Minimaldruck in der Vakuumatmosphäre nicht über- und nicht unterschritten wird, und daß die Kupferoberfläche überraschenderweise praktisch oxidfrei ist. Die Bindung zwischen Kupfer und Keramik kommt bei diesem Verfahren auch bei Sauerstoffpartialdrücken zustande, die teilweise erheblich unter den in den oben genannten Patentanmeldungen genannten Werten liegen.

Vorzugsweise wird eine hochreine Aluminiumoxidkeramik mit besonders glatter Oberfläche verwendet. Derartige Substrate werden bevorzugt in der Dünnfilmtechnik verwendet. Hochreine Keramik besitzt eine bessere Wärmeleitung und glattere, ebenere Oberflächen als weniger hochreine Keramik, wie sie derzeit in der Dickschicht-Technologie verwendet wird. Der Einschluß von Gasblasen ist bei Verwendung von Dickfilm-Keramiken mit ihrer Oberflächenrauhigkeit von etwa 1 μm weniger wahrscheinlich als bei Dünnfilm-Keramiken mit wesentlich geringeren Oberflächenrauhigkeiten, da bei ersteren die Gasblasen beim Aufschmelzen des $Cu_2O$/Cu-Eutektikums meist über die Oberflächen-Vertiefungen entweichen können, noch bevor der Verbindungsprozeß beendet ist.

Daher ist es eine besonderer Vorteil des Vakuum-Verfahrens, daß ohne großen Aufwand auch sehr glatte Dünnfilm-Keramik-Substrate großflächig blasenfrei mit Metallfolie verbunden werden können.

Aus der Tatsache, daß der erfindungsgemäße Prozeß im Vakuum durchgeführt wird, ergeben sich dann keine Behinderungen, wenn der Vakuumofen über Schleusen gefüllt und geleert wird.

Nachdem die Verbindung zwischen Keramik und Kupfer erfolgt ist, wird während des Abkühlens zwischen 1 065 °C und etwa 250 °C der Sauerstoffpartialdruck im Vakuumofen auf Werten unter 0,005 mbar gehalten. Dann kommen die freien Kupferoberflächen metallisch blank aus dem Ofen.

Vorteilhafterweise beträgt der Gesamtdruck im Ofen höchstens 0,1 mbar. Das bedeutet, daß außer Sauerstoff praktisch kein anderes reaktives Gas in technisch erheblichen Mengen vorhanden ist.

Anhand eines Ausführungsbeispieles soll das erfindungsgemäße Verfahren im einzelnen erläutert werden. Zunächst wird eine Kupferfolie auf wenigstens einer Seite oxidiert. Die Dicke des Oxids sollte etwa der Oberflächenrauhigkeit der Keramik entsprechen. Das Oxidieren kann chemisch oder thermisch erfolgen ; praktische Unterschiede ergeben sich für die Weiterverarbeitung dadurch nicht. Anschließend wird die Kupferfolie mit der oxidierten Seite flach auf ein Keramiksubstrat gelegt. Zum Ausgleich von thermischen Spannungen aufgrund der unterschiedlichen Wärmedehnung von Kupfer und Keramik können Kupferfolien auf beiden Seiten der Keramiksubstrate vorgesehen sein.

Der Vakuumofen wird zur Inbetriebnahme vor dem Aufheizen mit Stickstoff belüftet und nach dem Aufheizen gespült. Anschließend wird er auf einen Gesamtdruck von maximal 1 mbar, vorzugsweise 0,1 mbar evakuiert. Die mit Kupferfolie belegten Substrate werden auf Trägern liegend mit Hilfe von Schleusen durch einen Vakuumofen geschoben. Die Temperatur in der Reaktionszone des Vakuumofens liegt zwischen der Schmelztemperatur des Eutektiums $Cu_2O$/Cu und dem Schmelzpunkt des Kupfers, d. h. bei 1 072 °C. Im Inneren des Ofens herrscht ein Sauerstoff-Partialdruck zwischen 0,001 mbar und 0,03 mbar, wobei der Gesamtdruck der Ofenatmosphäre 1,0 mbar, vorzugsweise 0,1 mbar, nicht überschreiten soll. Der Sauerstoff-Partialdruck ist nötig, damit das für den Verbindungsprozeß so wichtige $Cu_2O$ nicht reduziert wird.

Die Substrate verbleiben für einige Minuten in der Hochtemperatur-Reaktionszone. Sobald der Verbindungsprozeß beendet und die Temperatur der Substrate kleiner als 1 065 °C ist, wird der Sauerstoff-Partialdruck auf Werte unter $5 \times 10^{-3}$ mbar abgesenkt, bis die Temperatur der Substrate unterhalb etwa 250 °C liegt. Die Substrate können mit metallisch blanken Kupferoberflächen aus dem Ofen entnommen werden und oxidieren praktisch nicht nach. Ein etwaiger Oxidanteil ist so gering, daß er bei einem nachfolgenden Lötvorgang durch übliche Flußmittel leicht beseitigt werden kann. Die Haftung des Kupfers an der Keramik ist blasenfrei und so gut, daß bei Abzugsversuchen Teile der Keramik mit dem Kupfer abgerissen werden.

**Ansprüche**

1. Verfahren zum direkten Verbinden von Kupferfolien, die oberflächlich eine Kupferoxidschicht tragen, mit Oxidkeramiksubstraten durch Erhitzen des mit der Kupferfolie belegten Keramiksubstrats in sauerstoffhaltiger Atmosphäre bis zu einer Temperatur oberhalb der eutektischen Temperatur von Cu und $Cu_2O$, aber unter-

halb der Schmelztemperatur von Cu, dadurch gekennzeichnet, daß das Erhitzen im Vakuumofen bei einem Druck von höchstens 1 mbar und einem Sauerstoff-Partialdruck zwischen 0,001 und 0,1 mbar in der Ofenatmosphäre durchgeführt wird und daß während des Abkühlens der Sauerstoff-Partialdruck unter 0,005 mbar gehalten wird.

2. Verfahren nach Anspruch 1, dadurch gekennzeichnet, daß hochreine Aluminiumoxidkeramik mit besonders glatter Oberfläche verwendet wird.

3. Verfahren nach Anspruch 1 oder 2, dadurch gekennzeichnet, daß der Vakuumofen über Schleusen gefüllt und geleert wird.

4. Verfahren nach Anspruch 1, 2 oder 3, dadurch gekennzeichnet, daß der Druck im Vakuumofen höchstens 0,1 mbar beträgt.

**Claims**

1. A method for the direct connection of copper foils, which carry a copper oxide layer on the surface, to oxide ceramic substrates by heating the ceramic substrate, which is covered with the copper foil, in an oxygen-containing atmosphere, up to a temperature above the eutectic temperature of Cu and $Cu_2O$, but below the melting temperature of Cu, characterized in that heating is carried out in a vacuum oven at a maximum pressure of 1 mbar and at an oxygen partial pressure between 0.001 and 0.1 mbar in the oven atmosphere, and in that during cooling, the oxygen partial pressure is maintained below 0.005 mbar.

2. A method according to claim 1, characterized in that extremely pure aluminium oxide ceramic with a particularly smooth surface is used.

3. A method according to claim 1 or 2, characterized in that the vacuum oven is filled and emptied by way of locks.

4. A method according to claim 1, 2 or 3, characterized in that the pressure in the vacuum oven is at most 0.1 mbar.

**Revendications**

1. Procédé pour établir une liaison directe de feuilles de cuivre, qui portent en surface une couche d'oxyde de cuivre, avec des substrats de céramique d'oxyde par le chauffage du substrat de céramique recouvert de la feuille de cuivre dans une atmosphère contenant de l'oxygène jusqu'à une température supérieure à la température eutectique de Cu et de $Cu_2O$, mais inférieure à la température de fusion de Cu, caractérisé en ce que le chauffage dans le four à vide est effectué à une pression d'au maximum 1 millibar et une pression partielle d'oxygène entre 0,001 et 0,1 millibar dans l'atmosphère du four et en ce que pendant le refroidissement, la pression partielle d'oxygène est maintenue inférieure à 0,005 millibar.

2. Procédé selon la revendication 1, caractérisé en ce qu'on utilise de la céramique d'oxyde d'aluminium de grande pureté ayant une surface particulièrement lisse.

3. Procédé selon la revendication 1 ou la revendication 2, caractérisé en ce qu'on remplit et on vide le four à vide par des sas.

4. Procédé selon la revendication 1, la revendication 2 ou la revendication 3, caractérisé en ce que la pression dans le four à vide est d'au maximum 0,1 millibar.